# EUROPEAN PATENT SPECIFICATION

(11) **EP 4 117 030 B1**
(45) Date of publication and mention of the grant of the patent: **26.08.2026**
(21) Application number: 21870481.5
(22) Date of filing: 24.09.2021
(51) Int. Cl.: H10D 89/60, H10W 20/20, H10W 20/40

(54) **SEMICONDUCTOR STRUCTURE AND METHOD FOR MANUFACTURING SAME**
HALBLEITERSTRUKTUR UND VERFAHREN ZUR HERSTELLUNG DAVON
STRUCTURE SEMI-CONDUCTRICE ET SON PROCÉDÉ DE FABRICATION

(30) Priority: 21.05.2021 CN 202110556051
(43) Date of publication of application: 11.01.2023
(73) Proprietor: Changxin Memory Technologies, Inc., Hefei City, Anhui 230000 (CN)
(72) Inventor: LIU, Chih-Cheng, Hefei, Anhui 230000 (CN)
(74) Representative: Lavoix
(86) International application number: PCT/CN2021/120107
(87) International publication number: WO 2022/241993

(56) References cited:
- CN-A- 102 024 782
- CN-A- 105 810 662
- CN-A- 108 140 615
- CN-A- 110 943 052
- CN-U- 208 819 867
- US-A1- 2010 237 386
- US-A1- 2011 095 367
- US-A1- 2014 191 410
- US-A1- 2019 393 049
- US-A1- 2020 381 512

## Description

### CROSS-REFERENCE TO RELATED APPLICATION

This application claims priority to Chinese Patent Application No. 202110556051.2, entitled "SEMICONDUCTOR STRUCTURE AND METHOD FOR MANUFACTURING SAME", filed on May 21, 2021.

### TECHNICAL FIELD

The disclosure relates to the technical field of the semiconductor, in particular to a semiconductor structure and a method for manufacturing the same.

### BACKGROUND

With the continuous development of the level of manufacturing the integrated circuit, electronic products tend to be miniaturized and highly integrated, and POP (Package-on-Package) technology of the semiconductor has come into being. The POP technology of the semiconductor, also known as the three-dimensional packaging technology, refers to the packaging technology in which two or more semiconductor structures are stacked vertically in a same package.

In the three-dimensional packaging technology, TSV (Through Silicon Via) technology is adopted to form the corresponding through hole in each semiconductor structure, and a conductive material is filled in the through holes to form the TSV structure. The vertical conduction between stacked semiconductor structures is realized by the TSV structures.

However, a large amount of charges are formed when the through holes are formed. The charges will be transferred to the semiconductor structures to damage the devices in the semiconductor structures and thus degrade the performance of the semiconductor structures. Related technologies are known from US 2010/237386 A1, US 2011/095367 A1, US 2020/381512 A1, US 2019/393049 A1 and CN 102 024 782 A.

### SUMMARY

The invention is defined by the independent claims. In a first aspect, embodiments of the disclosure provide a semiconductor structure and in a second aspect, embodiments of the disclosure provide a method for manufacturing a semiconductor structure.

In addition to the technical problem solved by the embodiments of the disclosure, the technical features in the technical scheme and the advantages brought by the technical features of the technical scheme described above, other technical problems which can be solved by the semiconductor structure and the method for manufacturing the same provided by the embodiments of the disclosure, other technical features included in the technical scheme and advantages brought by the other technical features will be further described in detail in specific implementations.

### BRIEF DESCRIPTION OF THE DRAWINGS

In order to illustrate the technical schemes in the embodiments of the disclosure or in the prior art more clearly, the drawings required for descriptions of the embodiments or the prior art will be briefly described below, and it is apparent that the drawings in the following descriptions are some embodiments of the disclosure, and other drawings may be obtained by those of ordinary skill in the art depending on the drawings, without creative efforts.
FIG. 1 illustrates a diagram from top view of a semiconductor structure provided by an embodiment of the disclosure;
FIG. 2 illustrates a cross-sectional diagram of a semiconductor structure provided by an embodiment of the disclosure;
FIG. 3 illustrates a process flowchart of a method for manufacturing a semiconductor structure provided by the disclosure; and
FIG. 4 illustrates a process flowchart of forming a first protection structure according to a method for manufacturing a semiconductor structure provided by an embodiment of the disclosure.

### DETAILED DESCRIPTION

The POP (Package-on-Package) technology of the semiconductor, also known as the three-dimensional packaging technology, refers to the packaging technology in which two or more semiconductor structures are stacked vertically in a same package, in which adjacent semiconductor structures are connected by TSV structures. In the process of forming through hole by etching the semiconductor structures with plasma, a large amount of electrons are generated. The electrons will be transferred to the devices of the semiconductor structures through conductive layers to damage the devices in the semiconductor structure and thus degrade the performance of the semiconductor structures.

To solve the foregoing technical problem, embodiments of the disclosure provide a semiconductor structure and a method for manufacturing the same. A first protection structure connected to a TSV structure is arranged in a second region. The first protection structure can absorb the current generated during forming the TSV structure, preventing the current from being transferred to a functional device to damage the functional device. Therefore, the service life of the functional device is increased, and further the performance of the semiconductor structure is improved.

To make the foregoing objectives, features and advantages of the embodiments of the disclosure to be more clear and understood more easily, the technical scheme of embodiments of the disclosure will be clearly and completely described with reference to the drawings of the embodiments of the disclosure. It is apparent that the described embodiments are merely part of and not all of the embodiments of the disclosure. All other embodiments obtained by those of ordinary skill in the art based on the embodiments of the disclosure without making creative efforts fall within the scope of the disclosure.

The semiconductor structure is not limited in the embodiments of the disclosure, and the semiconductor structure will be described below by taking a DRAM (Dynamic Random Access Memory) as an example, which is not limited thereto, and the semiconductor structure in the embodiments may be another structure.

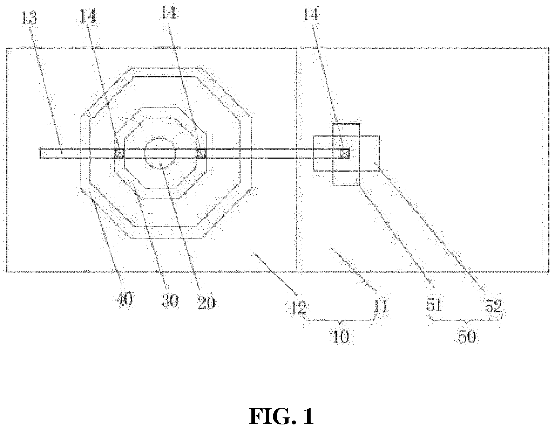

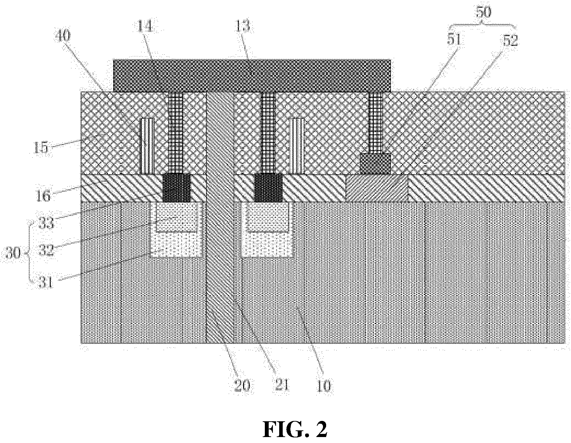

As shown in FIG. 1 and FIG. 2, an embodiment of the disclosure provides a semiconductor structure, including a substrate 10, and a TSV structure 20 and a first protection structure 30 arranged on the substrate 10.

The substrate 10 serves as a supporting component of the semiconductor structure for supporting other components provided thereon, in which the substrate 10 may be made of a semiconductor material which may be one or more of silicon, germanium, silicon germanide, and silicon carbide.

The substrate 10 includes a first region 11 and a second region 12 arranged adjacent to each other, in which the first region 11 is configured to arrange a functional device 50. For example the functional device 50 includes a gate electrode 51 and an active area 52.

As shown in FIG. 2, the second region 12 is configured to form the TSV structure 20 and the TSV structure 20 is electrically connected to the functional device 50, in which the TSV structure 20 may be directly connected to the functional device 50 or indirectly connected to the functional device 50. When the TSV structure 20 is indirectly connected to the functional device 50, a conductive layer 13 is arranged on the substrate 10, and the TSV structure 20 is electrically connected to the functional device 50 by a conductive layer 13.

It should be noted that not only the TSV structure 20 is formed in the second region 12, but also devices such as a word line or capacitor are formed in the second region 12. In this case, the TSV structure 20 and the devices formed in the second region 12 need to be insulated from each other.

During the formation of the TSV structure, a TSV through hole 21 is usually formed on the substrate by a plasma etching process, and then the TSV structure 20 is formed in the TSV through hole21 by a deposition process. When the etching is performed to form the TSV through hole 21, current is usually generated, which will be transferred to the functional device through the conductive layer or other components, causing damages to the functional device.

In view of this problem, according to the disclosure, the first protection structure 30 is arranged in the second region 12, in which the first protection structure 30 is arranged around the TSV structure 20 and electrically connected to the TSV structure 20, and the first protection structure 30 is located between the TSV structure 20 and the functional device 50. In this way, the current generated during forming the TSV structure will be preferentially transferred to the first protection structure 30 when being transferred to the outside. The first protection structure 30 can absorb the current, thereby preventing the current from being transferred to the functional device 50 and avoiding the damage to the functional device 50.

It should be noted that the TSV structure may be directly connected to the first protection structure 30 or may be electrically connected to the first protection structure 30 by the conductive layer 13.

According to some embodiments, as shown in FIG. 1 and FIG. 2, the first protection structure 30 includes a first well region 31, a second well region 32 and a doped region 33 which are arranged around the TSV structure 20, in which the second well region 32 is arranged within the first well region 31, the doped region 33 is arranged on the second well region 32, and the end, away from the second well region 32, of the doped region 33 is electrically connected to the TSV structure 20.

According to the embodiments, the first protection structure 30 formed by the first well region 31, the second well region 32 and the doped region 33 can absorb the current which is generated during forming the TSV through hole 21, and thus prevent the current from being transferred to the functional device through the conductive layer or other components, reducing the damage of the current to the functional device.

The first well region 31 is a P-type well region, the second well region 32 is an N-type well region, and the doped region 33 is a P+ doped region, so that a PNP junction is formed by the first protection structure, in which the ion doping concentration of the P+ doped region may be larger than that of the P-type well region. Alternatively, the first well region 31 is an N-type well region, the second well region 32 is a P-type well region, and the doped region 33 is an N+ doped region, so that an NPN junction is formed by the first protection structure, in which the ion doping concentration of the N+ doped region may be larger than that of the N-type well region.

Illustratively, the depth of an active area 52 of the functional device 50 is not larger than that of the doped region 33, so as to prevent the active area 52 of the functional device from extending into the second well region 32 and thus prevent affecting the performance of the functional device.

It should be noted that, multiple first protection structures 30 may be arranged at intervals in the circumferential direction of the TSV structure, or the first protection structure 30 may include an integrated annular PNP junction or NPN junction. The specific structure of the first protection structure is not specifically limited herein, as long as the first protection structure can absorb the current which is generated during forming the TSV structure.

Illustratively, the first well region 31 includes a first annular region extending in the circumferential direction of the TSV structure, the second well region 32 includes a second annular region extending in the circumferential direction of the TSV structure, the doped region 33 includes a third annular region extending in the circumferential direction of the TSV structure, in which the centers of the first annular region, the second annular region, and the third annular region are all located on the axis of the TSV structure 20, so that the current can be rapidly diffused to the first protection structure, and thus the amount of current absorbed by the first protection structure is increased. Therefore the performance of the semiconductor structure is improved.

In the direction perpendicular to the axis of the TSV structure, the widths of the first annular region, the second annular region and the third annular region may be equal or unequal. Illustratively, the width of the third annular region is smaller than that of the second annular region, and the width of the second annular region is smaller than that of the first annular region. That is, the width of the first annular region, the width of the second annular region, and the width of the third annular region decrease successively.

It should be noted that the width of the first annular region, the width of the second annular region and the width of the third annular region may be equal, which is not specifically limited in this embodiment.

According to some embodiments, the width of the first annular region is 0.3 µm~2 µm. If the width of the first annular region is smaller than 0.3 µm, the width of the first annular region is too small, and thus the amount of the current absorbed by the first protection structure will be reduced, in which the current is generated during forming the TSV through hole. If the width of the first annular region is too large, the junction capacitance of the first protection structure will be increased. Therefore, the width of the first annular region is limited in this embodiment, so as to ensure that the first protection structure fully absorbs the current generated during forming the TSV through hole and the junction capacitance of the first protection structure is reduced as well.

The distance between the first annular region and the TSV structure is further limited to be 2 µm~10 µm in this embodiment, so as to ensure that the first protection structure can fully absorb the current generated during forming the TSV through hole and at the same time too large area is not occupied.

According to some embodiments, an isolation structure 16and a dielectric layer 15 are further arranged between the substrate 10 and the conductive layer 13, in which the isolation structure 16 is used to isolate the active area 52 and the first protection structure 30. At least two conductive plugs 14 are arranged within the dielectric layer 15, in which two ends of one conductive plug 14 are directly connected to the conductive layer 13 and the functional device 50 respectively, and two ends of the other conductive plug 14 are directly connected to the conductive layer 13 and the first protection structure 30 respectively, and one end of the TSV structure 20 penetrates the dielectric layer 15 to be directly connected to the conductive layer 13.

According to the embodiments, the dielectric layer 15 arranged between the substrate 10 and the conductive layer 13 can prevent the conductive layer 13 from being electrically connected to other components of the substrate 10.

According to some embodiments, the semiconductor structure further includes a second protection structure 40 which is arranged around the first protection structure 30 and is located between the first protection structure 30 and the functional device 50, in which the second protection structure 40 is electrically insulated from the TSV structure 20. The second protection structure 40 may likewise be arranged around the TSV structure 20 and may be a wall-shaped metal wall.

The material of the TSV structure is usually copper and other metals, in which copper has a relatively large thermal expansion coefficient. In the process of using the semiconductor structure, the TSV structure or other functional devices will generate a large amount of heat, and thus the TSV structure is expanded due to heat, resulting in that stress deformation is formed in the contact area between the substrate and the TSV structure, which affects the performance of the semiconductor structure. Therefore, according to the embodiment, the second protection structure is formed on the substrate, and the second protection structure is configured to buffer the stress of the TSV structure on the peripheral dielectric layer and thus the performance of the semiconductor structure is improved.

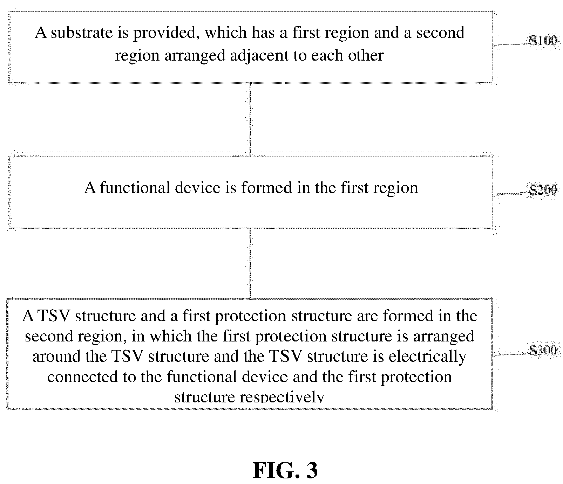

As shown in FIG. 3, in a second aspect, the disclosure provides a method for manufacturing a semiconductor structure, including operations as follows.

At S100, a substrate is provided, in which the substrate includes a first region and a second region arranged adjacent to each other.

The substrate may be a semiconductor substrate, such as a silicon (Si) substrate, which is definitely not limited in the embodiments of the disclosure. Illustratively, the substrate may also be a substrate of germanium (Ge), silicon on insulator (SOI), silicon germanide (SiGe), silicon carbide (SiC), gallium nitride (GaN), or the like.

The substrate 10 includes the first region 11 and the second region 12 which are arranged adjacent to each other. The sizes of the first region and the second region may be designed according to the actual situation, which is not specifically limited in the embodiment.

At S200, functional device is formed in the first region, in which, a device such as a transistor, a capacitor and the like is formed in the first region by a conventional process of manufacturing.

The process of manufacturing a transistor and a capacitor is the prior art, which will not be repeated herein.

At S300, a TSV structure and a first protection structure are formed in the second region, in which the first protection structure is arranged around the TSV structure, and the TSV structure is electrically connected to the functional device and the first protection structure, respectively.

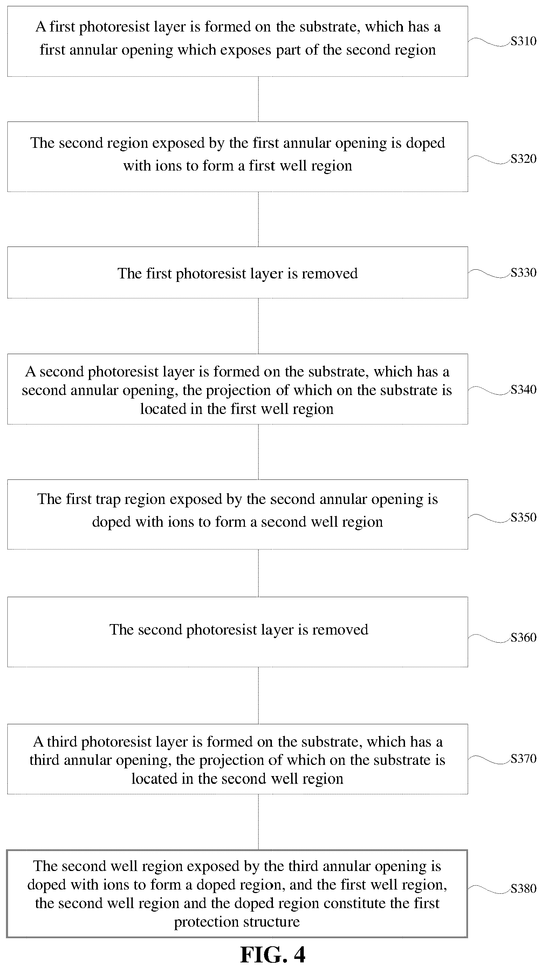

Illustratively, as shown in FIG. 4, at S310, a first photoresist layer is formed on the substrate 10, in which the first photoresist layer has a first annular opening which exposes the second region 12.

At S320, the second region 12 exposed by the first annular opening is doped with ions to form a first well region 31.

The first well region 31 may be a P-type well region, and illustratively, boron ions may be doped into the second region 12 exposed by the first annular opening to form the P-type well region in the second region 12.

The first well region 31 may further be an N-type well region, and illustratively, phosphorus ions or arsenic ions may be doped into the second region exposed by the first annular opening to form the N-type well region.

At S330, the first photoresist layer is removed, in which a cleaning solution may be used to remove the first photoresist layer.

At S340, a second photoresist layer is formed on the substrate, in which the second photoresist layer has a second annular opening, and the projection of the second annular opening on the substrate is located within the first well region.

Illustratively, the second photoresist layer of a certain thickness may be formed on the substrate by adopting a coating process, and then the second annular opening may be formed in the second photoresist layer by a process of exposing-developing, or etching.

It should be noted that, according to the embodiment, the size of the second annular opening is not limited by the foregoing implementation. Alternatively, the projection of the second annular opening on the substrate may exactly expose the first well region.

At Step S350, the first well region exposed by the second annular opening is doped with ions to form a second well region.

When the first well region 31 is a P-type well region, the second well region 32 is an N-type well region, and illustratively, phosphorus ions or arsenic ions may be doped into the first well region 31 exposed by the second annular opening to form the N-type well region.

When the first well region 31 is an N-type well region, the second well region 32 is a P-type well region, and illustratively, boron ions may be doped into the first well region exposed by the second annular opening to form the P-type well region.

At S360, the second photoresist layer is removed, in which a cleaning solution may be adopted to remove the second photoresist layer.

At S370, a third photoresist layer is formed on the substrate, in which the third photoresist layer has a third annular opening, and the projection of the third annular opening on the substrate is located in the second well region.

It should be noted that, according to the embodiment, the size of the third annular opening is not limited by the foregoing implementation. Alternatively, the projection of the third annular opening on the substrate may exactly expose the second well region.

At S380, the second well region exposed by the third annular opening is doped to form a doped region, in which the first well region, the second well region and the doped region constitute the first protection structure.

When the first well region 31 is a P-type well region and the second well region 32 is an N-type well region, the doped region 33 is a P+ doped region. Illustratively, boron ions may be doped into the second well region exposed by the third annular opening to form the P+ doped region.

When the first well region 31 is an N-type well region and the second well region 32 is a P-type well region, the doped region 33 is an N+ doped region. Illustratively, phosphorus ions and arsenic ions may be doped into the second well region exposed by the third annular opening to form the N+ doped region.

According to some embodiments, providing the substrate further includes the following actions.

A dielectric layer is formed on the substrate, for example, by a CVD (chemical vapor deposition) process or a PVD (physical vapor deposition) process.

After the dielectric layer is formed, at least two through holes are formed in the dielectric layer, in which the first protection structure is exposed by one through hole, and the functional device is exposed by the other.

Illustratively, the dielectric layer may be patterned to form at least two through holes in the dielectric layer, for example, three through holes are arranged in the dielectric layer, in which the functional device is exposed by one of the through holes and the first protection structure is exposed by the other two through holes.

After the through holes are formed, conductive materials may be deposited in the through holes by a PVD (physical vapor deposition) process or a CVD (chemical vapor deposition) process to form conductive plugs.

Finally, a conductive layer is formed on the dielectric layer by a CVD (chemical vapor deposition) process, a PVD (physical vapor deposition) process or an ALD (atomic layer deposition) process, in which at least conductive plugs are covered by the conductive layer, so as to realize that the conductive layer is electrically connected to the first protection structure and the TSV structure respectively.

After the conductive layer is formed, the method for manufacturing a semiconductor structure further includes the following operations.

Firstly, a fourth photoresist layer is formed on the surface, away from the conductive layer, of the substrate, in which the fourth photoresist layer has an opening pattern, the projection of the opening pattern on the surface of the substrate is located within the first protection structure.

Secondly, the substrate and the dielectric layer in the opening pattern are etched by plasma to form a TSV through hole exposing the conductive layer, in which electrons are generated during forming the TSV through hole, and when the electrons are transferred to the devices of the semiconductor structure through the conductive layer, the charges are preferentially transferred to the first protection structure, which absorbs at least part of the electrons, thereby reducing the damage to the functional device and further improving the performance of the semiconductor structure

Finally, the TSV through hole is filled with a conductive material to form the TSV structure.

Embodiments or implementations herein are described in a progressive manner, with each embodiment emphatically illustrating differences from other embodiments, and the same and similar parts of the embodiments may be referred to each other.

In the descriptions of the specification, descriptions of the reference terms such as "an embodiment" "some embodiments", "illustrative embodiment", "an example", "specific example" or "some examples" denote that at least one embodiment or example of the disclosure includes the specific features, structures, materials, or features described according to the embodiments or examples.

In the specification, schematic expression of the foregoing terms does not necessarily refer to the same implementations or embodiments. Further, the specific features, structures, materials or characteristics described may be combined in a suitable manner in any one or more implementations or embodiments.

Finally, it should be noted that the foregoing embodiments are merely used to illustrate the technical scheme of the disclosure, and not intend to limit the disclosure. Although the disclosure is described in detail with reference to the foregoing embodiments, it should be understood by those of ordinary skill in the art that the technical scheme described in the foregoing embodiments may further be modified or some or all of the technical features in the technical scheme may be equivalently substituted, and the modifications or substitutions do not depart from the scope of the technical scheme of the embodiments of the disclosure.

## Claims

1. A semiconductor structure, comprising:
a substrate (10) having a first region (11) and a second region (12) arranged adjacent to each other, the first region (11) being provided with a functional device (50);
a TSV structure (20), arranged in the second region and electrically connected to the functional device (50); and
a first protection structure (30), arranged around the TSV structure (20) and electrically connected to the TSV structure (20);
a TSV through hole (21), wherein the TSV structure (20) is formed in the TSV through hole (21);
wherein the first protection structure (30) is positioned between the TSV structure (20) and the functional device (50), and is configured to absorb a current which is generated during forming the TSV through hole (21),
**characterized in that**, the first protection structure (30) comprises a first well region (31), a second well region (32) and a doped region (33) which are arranged around the TSV structure (20) ;
the second well region (32) is arranged in the first well region (31); and
the doped region (33) is arranged on the second well region (32), and an end, away from the second well region (32), of the doped region (33) is electrically connected to the TSV structure (20);
wherein the first well region (31) comprises a first annular region extending in a circumferential direction of the TSV structure (20), and a distance between the first annular region and the TSV structure (20) is 2 µm~10 µm;
wherein the first well region (31) is a P-type well region, the second well region (32) is an N-type well region and the doped region (33) is a P+ doped region (33); or
the first well region (31) is an N-type well region, the second well region (32) is a P-type well region and the doped region (33) is an N+ doped region.

2. The semiconductor structure of claim 1, wherein a depth of an active area (52) of the functional device (50) is not larger than a depth of the doped region (33).

3. The semiconductor structure of claim 1, wherein the second well region (32) comprises a second annular region extending in the circumferential direction of the TSV structure (20), and the doped region (33) comprises a third annular region extending in the circumferential direction of the TSV structure (20);
a center of the first annular region, a center of the second annular region and a center of the third annular region are all located on an axis of the TSV structure (20); and
in a direction perpendicular to the axis of the TSV structure (20), a width of the third annular region is smaller than a width of the second annular region, and the width of the second annular region is smaller than a width of the first annular region.

4. The semiconductor structure of claim 1, wherein a shape of cross-section, parallel to a surface of the substrate (10), of the first annular region comprises a polygon or a circular ring.

5. The semiconductor structure of claim 1, wherein the width of the first annular region is 0.3 µm~2 µm.

6. The semiconductor structure of claim 1, wherein a conductive layer (13) is provided on the substrate (10), and the TSV structure (20) is electrically connected to the functional device (50) and the first protection structure (30) by the conductive layer (13).

7. The semiconductor structure of claim 6, wherein a dielectric layer (15) is further arranged between the substrate (10) and the conductive layer (13), at least two conductive plugs (14) are arranged in the dielectric layer (15), two ends of one conductive plug (14) are directly connected to the conductive layer (13) and the functional device (50) respectively, and two ends of another conductive plug (14) are directly connected to the conductive layer (13) and the first protection structure (30) respectively; and
one end of the TSV structure (20) which is away from the substrate (10), penetrates the dielectric layer (15) and is directly connected to the conductive layer (13).

8. The semiconductor structure of claim 7, further comprising:
a second protection structure (40) arranged around the first protection structure (30) and located between the first protection structure (30) and the functional device (50),
wherein, the second protection structure (40) is electrically insulated from the TSV structure (20).

9. A method for manufacturing a semiconductor structure, **characterized in that**, the method comprises:
providing a substrate (10), the substrate (10) having a first region (11) and a second region (12) arranged adjacent to each other (S100);
forming a functional device (50) in the first region (11) (S200); and
forming a TSV structure (20) and a first protection structure (30) in the second region (S300),
wherein the first protection structure (30) is arranged around the TSV structure (20) and the TSV structure (20) is electrically connected to the functional device (50) and the first protection structure (30), respectively;
**characterized in that**, forming the TSV structure (20) and the first protection structure (30) in the second region (12) comprises:
forming a first photoresist layer on the substrate, (10) the first photoresist layer being provided with a first annular opening, a part of the second region (12) being exposed by the first annular opening (S310);
performing ion doping on the second region (12) exposed by the first annular opening to form a first well region (31) (S320);
removing the first photoresist layer (S330);
forming a second photoresist layer on the substrate (10), the second photoresist layer being provided with a second annular opening, a projection of the second annular opening on the substrate (10) being located within the first well region (31) (S340);
performing doping on the first well region (31) exposed by the second annular opening to form a second well region (32) (S350);
removing the second photoresist layer (S360);
forming a third photoresist layer on the substrate (10), the third photoresist layer being provided with a third annular opening, a projection of the third annular opening on the substrate (10) being located within the second well region (32) (S370); and
performing doping on the second well region (32) exposed by the third annular opening to form a doped region (33), and the first well region (31), the second well region (32) and the doped region (33) constituting the first protection structure (30) (S380);
wherein the first well region (31) is a P-type well region, the second well region (32) is an N-type well region and the doped region (33) is a P+ doped region (33); or
the first well region (31) is an N-type well region, the second well region (32) is a P-type well region and the doped region (33) is an N+ doped region.

10. The method for manufacturing a semiconductor structure of claim 9, further comprising:
forming a dielectric layer (15) on the substrate (10);
forming at least two through holes in the dielectric layer (15), wherein the first protection structure (30) is exposed by one through hole and the functional device (50) is exposed by another through hole;
forming conductive plugs (14) in the through holes; and
forming a conductive layer (13) on the dielectric layer (15), and at least the conductive plugs (14) being covered by the conductive layer (13).

11. The method for manufacturing a semiconductor structure of claim 10, wherein forming the TSV structure (20) in the second region comprises:
forming a fourth photoresist layer on a surface, away from the conductive layer (13), of the substrate (10), the fourth photoresist layer being provided with an opening pattern, a projection of the opening pattern on the surface (10) of the substrate being located within the first protection structure (30);
etching the substrate (10) and the dielectric layer (15) along the opening pattern by plasma to form a TSV through hole (21) exposing the conductive layer (13); and filling a conductive material in the TSV through hole (21) to form the TSV structure (20).

## Patentansprüche

1. Eine Halbleiterstruktur, umfassend:
ein Substrat (10), das einen ersten Bereich (11) und einen zweiten Bereich (12) aufweist, die zueinander benachbart angeordnet sind, wobei der erste Bereich (11) mit einem funktionalen Bauelement (50) versehen ist;
eine TSV-Struktur (20), die in dem zweiten Bereich angeordnet ist und elektrisch mit dem funktionalen Bauelement (50) verbunden ist; und
eine erste Schutzstruktur (30), die um die TSV-Struktur (20) herum angeordnet ist und elektrisch mit der TSV-Struktur (20) verbunden ist;
ein TSV-Durchgangsloch (21), wobei die TSV-Struktur (20) in dem TSV-Durchgangsloch (21) ausgebildet ist;
wobei die erste Schutzstruktur (30) zwischen der TSV-Struktur (20) und dem funktionalen Bauelement (50) positioniert ist und dazu konfiguriert ist, einen Strom zu absorbieren, der während des Ausbildens des TSV-Durchgangslochs (21) erzeugt wird,
**dadurch gekennzeichnet, dass** die erste Schutzstruktur (30) einen ersten Wannenbereich (31), einen zweiten Wannenbereich (32) und einen dotierten Bereich (33) umfasst, die um die TSV-Struktur (20) herum angeordnet sind;
der zweite Wannenbereich (32) in dem ersten Wannenbereich (31) angeordnet ist; und
der dotierte Bereich (33) auf dem zweiten Wannenbereich (32) angeordnet ist, und ein Ende des dotierten Bereichs (33), das von dem zweiten Wannenbereich (32) entfernt ist, elektrisch mit der TSV-Struktur (20) verbunden ist;
wobei der erste Wannenbereich (31) einen ersten ringförmigen Bereich umfasst, der sich in einer Umfangsrichtung der TSV-Struktur (20) erstreckt, und ein Abstand zwischen dem ersten
ringförmigen Bereich und der TSV-Struktur (20) 2 µm~10 µm beträgt;
wobei der erste Wannenbereich (31) ein Wannenbereich vom P-Typ ist, der zweite Wannenbereich (32) ein Wannenbereich vom N-Typ ist und der dotierte Bereich (33) ein P+-dotierter Bereich (33) ist; oder
der erste Wannenbereich (31) ein Wannenbereich vom N-Typ ist, der zweite Wannenbereich (32) ein Wannenbereich vom P-Typ ist und der dotierte Bereich (33) ein N+-dotierter Bereich ist.

2. Die Halbleiterstruktur nach Anspruch 1, wobei eine Tiefe eines aktiven Bereichs (52) des funktionalen Bauelements (50) nicht größer als eine Tiefe des dotierten Bereichs (33) ist.

3. Die Halbleiterstruktur nach Anspruch 1, wobei der zweite Wannenbereich (32) einen zweiten ringförmigen Bereich umfasst, der sich in der Umfangsrichtung der TSV-Struktur (20) erstreckt, und der dotierte Bereich (33) einen dritten ringförmigen Bereich umfasst, der sich in der Umfangsrichtung der TSV-Struktur (20) erstreckt;
ein Zentrum des ersten ringförmigen Bereichs, ein Zentrum des zweiten ringförmigen Bereichs und ein Zentrum des dritten ringförmigen Bereichs alle auf einer Achse der TSV-Struktur (20) liegen; und
in einer Richtung senkrecht zu der Achse der TSV-Struktur (20), eine Breite des dritten ringförmigen Bereichs kleiner als eine Breite des zweiten ringförmigen Bereichs ist, und die Breite des zweiten ringförmigen Bereichs kleiner als eine Breite des ersten ringförmigen Bereichs ist.

4. Die Halbleiterstruktur nach Anspruch 1, wobei eine Form eines Querschnitts, parallel zu einer Oberfläche des Substrats (10), des ersten ringförmigen Bereichs ein Polygon oder einen kreisförmigen Ring umfasst.

5. Die Halbleiterstruktur nach Anspruch 1, wobei die Breite des ersten ringförmigen Bereichs 0,3 µm~2 µm beträgt.

6. Die Halbleiterstruktur nach Anspruch 1, wobei eine leitfähige Schicht (13) auf dem Substrat (10) bereitgestellt ist, und die TSV-Struktur (20) durch die leitfähige Schicht (13) elektrisch mit dem funktionalen Bauelement (50) und der ersten Schutzstruktur (30) verbunden ist.

7. Die Halbleiterstruktur nach Anspruch 6, wobei eine dielektrische Schicht (15) ferner zwischen dem Substrat (10) und der leitfähigen Schicht (13) angeordnet ist, mindestens zwei leitfähige Stopfen (14) in der dielektrischen Schicht (15) angeordnet sind, zwei Enden eines leitfähigen Stopfens (14) direkt mit der leitfähigen Schicht (13) beziehungsweise dem funktionalen Bauelement (50) verbunden sind, und zwei Enden eines anderen leitfähigen Stopfens (14) direkt mit der leitfähigen Schicht (13) beziehungsweise der ersten Schutzstruktur (30) verbunden sind; und
ein Ende der TSV-Struktur (20), das von dem Substrat (10) entfernt ist, die dielektrische Schicht (15) durchdringt und direkt mit der leitfähigen Schicht (13) verbunden ist.

8. Die Halbleiterstruktur nach Anspruch 7, ferner umfassend:
eine zweite Schutzstruktur (40), die um die erste Schutzstruktur (30) herum angeordnet ist und zwischen der ersten Schutzstruktur (30) und dem funktionalen Bauelement (50) angeordnet ist,
wobei die zweite Schutzstruktur (40) elektrisch von der TSV-Struktur (20) isoliert ist.

9. Ein Verfahren zum Herstellen einer Halbleiterstruktur, **dadurch gekennzeichnet, dass** das Verfahren Folgendes umfasst:
Bereitstellen eines Substrats (10), wobei das Substrat (10) einen ersten Bereich (11) und einen zweiten Bereich (12) aufweist, die zueinander benachbart angeordnet sind (S100);
Ausbilden eines funktionalen Bauelements (50) in dem ersten Bereich (11) (S200); und
Ausbilden einer TSV-Struktur (20) und einer ersten Schutzstruktur (30) in dem zweiten Bereich (S300),
wobei die erste Schutzstruktur (30) um die TSV-Struktur (20) herum angeordnet ist und die TSV-Struktur (20) elektrisch mit dem funktionalen Bauelement (50) beziehungsweise der ersten Schutzstruktur (30) verbunden ist;
**dadurch gekennzeichnet, dass** das Ausbilden der TSV-Struktur (20) und der ersten Schutzstruktur (30) in dem zweiten Bereich (12) Folgendes umfasst:
Ausbilden einer ersten Photoresistschicht auf dem Substrat, (10), wobei die erste Photoresistschicht mit einer ersten ringförmigen Öffnung versehen ist, wobei ein Teil des zweiten Bereichs (12) durch die erste ringförmige Öffnung freigelegt wird (S310);
Durchführen einer Ionendotierung an dem zweiten Bereich (12), der durch die erste ringförmige Öffnung freigelegt ist, um einen ersten Wannenbereich (31) auszubilden (S320);
Entfernen der ersten Photoresistschicht (S330);
Ausbilden einer zweiten Photoresistschicht auf dem Substrat (10), wobei die zweite Photoresistschicht mit einer zweiten ringförmigen Öffnung versehen ist, wobei eine Projektion der zweiten ringförmigen Öffnung auf das Substrat (10) innerhalb des ersten Wannenbereichs (31) liegt (S340);
Durchführen einer Dotierung an dem ersten Wannenbereich (31), der durch die zweite ringförmige Öffnung freigelegt ist, um einen zweiten Wannenbereich (32) auszubilden (S350);
Entfernen der zweiten Photoresistschicht (S360);
Ausbilden einer dritten Photoresistschicht auf dem Substrat (10), wobei die dritte Photoresistschicht mit einer dritten ringförmigen Öffnung versehen ist, wobei eine Projektion der dritten ringförmigen Öffnung auf das Substrat (10) innerhalb des zweiten Wannenbereichs (32) liegt (S370); und
Durchführen einer Dotierung an dem zweiten Wannenbereich (32), der durch die dritte ringförmige Öffnung freigelegt ist, um einen dotierten Bereich (33) auszubilden, und wobei der erste Wannenbereich (31), der zweite Wannenbereich (32) und der dotierte Bereich (33) die erste Schutzstruktur (30) bilden (S380);
wobei der erste Wannenbereich (31) ein Wannenbereich vom P-Typ ist, der zweite Wannenbereich (32) ein Wannenbereich vom N-Typ ist und der dotierte Bereich (33) ein P+-dotierter Bereich (33) ist; oder
der erste Wannenbereich (31) ein Wannenbereich vom N-Typ ist, der zweite Wannenbereich (32) ein Wannenbereich vom P-Typ ist und der dotierte Bereich (33) ein N+-dotierter Bereich ist.

10. Das Verfahren zum Herstellen einer Halbleiterstruktur nach Anspruch 9, ferner umfassend:
Ausbilden einer dielektrischen Schicht (15) auf dem Substrat (10);
Ausbilden von mindestens zwei Durchgangslöchern in der dielektrischen Schicht (15), wobei die erste Schutzstruktur (30) durch ein Durchgangsloch freigelegt wird und das funktionale Bauelement (50) durch ein anderes Durchgangsloch freigelegt wird;
Ausbilden von leitfähigen Stopfen (14) in den Durchgangslöchern; und
Ausbilden einer leitfähigen Schicht (13) auf der dielektrischen Schicht (15), und wobei mindestens die leitfähigen Stopfen (14) durch die leitfähige Schicht (13) bedeckt werden.

11. Das Verfahren zum Herstellen einer Halbleiterstruktur nach Anspruch 10, wobei
das Ausbilden der TSV-Struktur (20) in dem zweiten Bereich Folgendes umfasst:
Ausbilden einer vierten Photoresistschicht auf einer Oberfläche des Substrats (10), die von der leitfähigen Schicht (13) entfernt ist, wobei die vierte Photoresistschicht mit einem Öffnungsmuster versehen ist, wobei eine Projektion des Öffnungsmusters auf die Oberfläche (10) des Substrats innerhalb der ersten Schutzstruktur (30) liegt;
Ätzen des Substrats (10) und der dielektrischen Schicht (15) entlang des Öffnungsmusters durch Plasma, um ein TSV-Durchgangsloch (21) auszubilden, das die leitfähige Schicht (13) freilegt; und Füllen eines leitfähigen Materials in das TSV-Durchgangsloch (21), um die TSV-Struktur (20) auszubilden.

## Revendications

1. Une structure semi-conductrice, comprenant :
un substrat (10) ayant une première région (11) et une seconde région (12) agencées adjacentes l'une à l'autre, la première région (11) étant pourvue d'un dispositif fonctionnel (50) ;
une structure TSV (20), agencée dans la seconde région et connectée électriquement au dispositif fonctionnel (50) ; et
une première structure de protection (30), agencée autour de la structure TSV (20) et connectée électriquement à la structure TSV (20) ;
un trou traversant TSV (21), dans lequel la structure TSV (20) est formée dans le trou traversant TSV (21) ;
dans laquelle la première structure de protection (30) est positionnée entre la structure TSV (20) et le dispositif fonctionnel (50), et est configurée pour absorber un courant qui est généré pendant la formation du trou traversant TSV (21),
**caractérisée en ce que**, la première structure de protection (30) comprend une première région de puits (31), une seconde région de puits (32) et une région dopée (33) qui sont agencées autour de la structure TSV (20) ;
la seconde région de puits (32) est agencée dans la première région de puits (31) ; et
la région dopée (33) est agencée sur la seconde région de puits (32), et une extrémité, éloignée de la seconde région de puits (32), de la région dopée (33) est connectée électriquement à la structure TSV (20) ;
dans laquelle la première région de puits (31) comprend une première région annulaire s'étendant dans une direction circonférentielle de la structure TSV (20), et une distance entre la première région annulaire et la structure TSV (20) est de 2 µm~10 µm ;
dans laquelle la première région de puits (31) est une région de puits de type P, la seconde région de puits (32) est une région de puits de type N et la région dopée (33) est une région dopée P+ (33) ; ou
la première région de puits (31) est une région de puits de type N, la seconde région de puits (32) est une région de puits de type P et la région dopée (33) est une région dopée N+.

2. La structure semi-conductrice selon la revendication 1, dans laquelle une profondeur d'une zone active (52) du dispositif fonctionnel (50) n'est pas supérieure à une profondeur de la région dopée (33).

3. La structure semi-conductrice selon la revendication 1, dans laquelle la seconde région de puits (32) comprend une deuxième région annulaire s'étendant dans la direction circonférentielle de la structure TSV (20), et la région dopée (33) comprend une troisième région annulaire s'étendant dans la direction circonférentielle de la structure TSV (20) ;
un centre de la première région annulaire, un centre de la deuxième région annulaire et un centre de la troisième région annulaire sont tous situés sur un axe de la structure TSV (20) ; et
dans une direction perpendiculaire à l'axe de la structure TSV (20), une largeur de la troisième région annulaire est inférieure à une largeur de la deuxième région annulaire, et la largeur de la deuxième région annulaire est inférieure à une largeur de la première région annulaire.

4. La structure semi-conductrice selon la revendication 1, dans laquelle une forme de section transversale, parallèle à une surface du substrat (10), de la première région annulaire comprend un polygone ou un anneau circulaire.

5. La structure semi-conductrice selon la revendication 1, dans laquelle la largeur de la première région annulaire est de 0,3 µm~2 µm.

6. La structure semi-conductrice selon la revendication 1, dans laquelle une couche conductrice (13) est prévue sur le substrat (10), et la structure TSV (20) est connectée électriquement au dispositif fonctionnel (50) et à la première structure de protection (30) par la couche conductrice (13).

7. La structure semi-conductrice selon la revendication 6, dans laquelle une couche diélectrique (15) est en outre agencée entre le substrat (10) et la couche conductrice (13), au moins deux plots conducteurs (14) sont agencés dans la couche diélectrique (15), deux extrémités d'un plot conducteur (14) sont directement connectées à la couche conductrice (13) et au dispositif fonctionnel (50) respectivement, et deux extrémités d'un autre plot conducteur (14) sont directement connectées à la couche conductrice (13) et à la première structure de protection (30) respectivement ; et
une extrémité de la structure TSV (20) qui est éloignée du substrat (10), pénètre dans la couche diélectrique (15) et est directement connectée à la couche conductrice (13).

8. La structure semi-conductrice selon la revendication 7, comprenant en outre :
une seconde structure de protection (40) agencée autour de la première structure de protection (30) et située entre la première structure de protection (30) et le dispositif fonctionnel (50),
dans laquelle, la seconde structure de protection (40) est électriquement isolée de la structure TSV (20).

9. Un procédé de fabrication d'une structure semi-conductrice, **caractérisé en ce que**, le procédé comprend :
fournir un substrat (10), le substrat (10) ayant une première région (11) et une seconde région (12) agencées adjacentes l'une à l'autre (S100) ;
former un dispositif fonctionnel (50) dans la première région (11) (S200) ; et
former une structure TSV (20) et une première structure de protection (30) dans la seconde région (S300),
dans lequel la première structure de protection (30) est agencée autour de la structure TSV (20) et la structure TSV (20) est connectée électriquement au dispositif fonctionnel (50) et à la première structure de protection (30), respectivement ;
**caractérisé en ce que**, la formation de la structure TSV (20) et de la première structure de protection (30) dans la seconde région (12) comprend :
former une première couche de résine photosensible sur le substrat, (10) la première couche de résine photosensible étant pourvue d'une première ouverture annulaire, une partie de la seconde région (12) étant exposée par la première ouverture annulaire (S310) ;
effectuer un dopage ionique sur la seconde région (12) exposée par la première ouverture annulaire pour former une première région de puits (31) (S320) ;
retirer la première couche de résine photosensible (S330) ;
former une deuxième couche de résine photosensible sur le substrat (10), la deuxième couche de résine photosensible étant pourvue d'une deuxième ouverture annulaire, une projection de la deuxième ouverture annulaire sur le substrat (10) étant située au sein de la première région de puits (31) (S340) ;
effectuer un dopage sur la première région de puits (31) exposée par la deuxième ouverture annulaire pour former une seconde région de puits (32) (S350) ;
retirer la deuxième couche de résine photosensible (S360) ;
former une troisième couche de résine photosensible sur le substrat (10), la troisième couche de résine photosensible étant pourvue d'une troisième ouverture annulaire, une projection de la troisième ouverture annulaire sur le substrat (10) étant située au sein de la seconde région de puits (32) (S370) ; et
effectuer un dopage sur la seconde région de puits (32) exposée par la troisième ouverture annulaire pour former une région dopée (33), et la première région de puits (31), la seconde région de puits (32) et la région dopée (33) constituant la première structure de protection (30) (S380) ;
dans lequel la première région de puits (31) est une région de puits de type P, la seconde région de puits (32) est une région de puits de type N et la région dopée (33) est une région dopée P+ (33) ; ou
la première région de puits (31) est une région de puits de type N, la seconde région de puits (32) est une région de puits de type P et la région dopée (33) est une région dopée N+.

10. Le procédé de fabrication d'une structure semi-conductrice selon la revendication 9, comprenant en outre :
former une couche diélectrique (15) sur le substrat (10) ;
former au moins deux trous traversants dans la couche diélectrique (15), dans lequel la première structure de protection (30) est exposée par un trou traversant et le dispositif fonctionnel (50) est exposé par un autre trou traversant ;
former des plots conducteurs (14) dans les trous traversants ; et
former une couche conductrice (13) sur la couche diélectrique (15), et au moins les plots conducteurs (14) étant recouverts par la couche conductrice (13).

11. Le procédé de fabrication d'une structure semi-conductrice selon la revendication 10, dans lequel la formation de la structure TSV (20) dans la seconde région comprend :
former une quatrième couche de résine photosensible sur une surface, éloignée de la couche conductrice (13), du substrat (10), la quatrième couche de résine photosensible étant pourvue d'un motif d'ouverture, une projection du motif d'ouverture sur la surface (10) du substrat étant située au sein de la première structure de protection (30) ;
graver le substrat (10) et la couche diélectrique (15) le long du motif d'ouverture par plasma pour former un trou traversant TSV (21) exposant la couche conductrice (13) ; et remplir le trou traversant TSV (21) d'un matériau conducteur pour former la structure TSV (20).
